# DEMANDE DE BREVET EUROPEEN

(11) **EP 3 799 120 A1**
(43) Date de publication de la demande: **31.03.2021**
(21) Numéro de dépôt: 20197301.3
(22) Date de dépôt: 21.09.2020
(51) Int. Cl.: H01L 23/60, H01L 21/762, H01L 27/02

(54) **TRANCHÉES ISOLANTES POUR LES CIRCUITS ESD**

(30) Priorité: 30.09.2019 FR 1910806
(71) Demandeur: STMicroelectronics (Tours) SAS, 37100 Tours (FR)
(72) Inventeur: BOUFNICHEL, Mohamed, 37380 MONNAIE (FR)
(74) Mandataire: Cabinet Beaumont

(57) **Abrégé**

La présente description concerne une tranchée isolante (3) dans un substrat semi-conducteur (37), comportant un espace clos qui contient un gaz.

## Description

### Domaine technique

La présente description concerne de façon générale les dispositifs électroniques et, plus particulièrement, les dispositifs électroniques de protection contre des décharges électrostatiques.

### Technique antérieure

On connaît différents dispositifs de prévention et de protection contre des décharges électrostatiques.

### Résumé de l'invention

Il existe un besoin d'améliorer les performances des dispositifs de protection contre des décharges électrostatiques actuels.

Un mode de réalisation prévoit une tranchée isolante dans un substrat semi-conducteur, comportant un espace clos qui contient un gaz.

Selon un mode de réalisation, 60 % du volume de l'espace clos de la tranchée est occupé par le gaz.

Un mode de réalisation prévoit un procédé de fabrication d'une tranchée dans un substrat semi-conducteur, comprenant une étape d'enfermement d'un gaz dans un espace clos.

Selon un mode de réalisation, le procédé comprend une étape d'ouverture du substrat par gravure ionique réactive profonde pour former la tranchée.

Selon un mode de réalisation, la tranchée est fermée par un dépôt, non-conforme, d'un premier oxyde à la surface de celle-ci.

Selon un mode de réalisation, le premier oxyde est du dioxyde de silicium.

Selon un mode de réalisation, le dépôt non-conforme est effectué par dépôt chimique en phase vapeur assisté par plasma.

Selon un mode de réalisation, le dépôt non-conforme est effectué par dépôt physique en phase vapeur.

Selon un mode de réalisation, le premier oxyde a une épaisseur comprise entre 0,1 et 3 µm, de préférence entre 0,5 et 1,5 µm, l'épaisseur étant préférentiellement égale à environ 1 µm, par exemple égale à 1 µm.

Selon un mode de réalisation, les parois de la tranchée sont oxydées thermiquement par un deuxième oxyde.

Selon un mode de réalisation, le deuxième oxyde est du dioxyde de silicium.

Selon un mode de réalisation, le deuxième oxyde a une épaisseur comprise entre 100 et 900 nm, de préférence entre 200 et 250 nm, l'épaisseur étant préférentiellement égale à environ 215 nm, par exemple égale à 215 nm.

Selon un mode de réalisation, la tranchée, avant oxydation, a une largeur comprise entre 0,5 et 4 µm, de préférence entre 1 et 2 µm, la largeur étant préférentiellement égale à environ 1,6 µm, par exemple égale à 1,6 µm.

Selon un mode de réalisation, la tranchée, avant oxydation, a une profondeur comprise entre 10 et 25 µm, de préférence entre 15 et 20 µm, la profondeur étant préférentiellement égale à environ 17 µm, de préférence égale à 17 µm.

Selon un mode de réalisation, le gaz est choisi parmi de l'air sec, du diazote, de l'argon ou un gaz utilisé pour la fabrication des tranchées, par exemple de l'orthosilicate de tétraéthyle.

Un mode de réalisation prévoir un dispositif de protection contre des décharges électrostatiques comprenant au moins une tranchée.

Selon un mode de réalisation, le dispositif possède une tension de blocage inférieure ou égale à 30 V.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique, un exemple de circuit électronique de protection contre des décharges électrostatiques du type auquel s'appliquent les modes de réalisation décrits ;
la figure 2 représente un exemple de caractéristique courant-tension d'un dispositif de protection contre des décharges électrostatiques ;
la figure 3 est une vue en coupe, partielle et schématique, d'un circuit de protection contre des décharges électrostatiques réalisé sous forme intégré ; et
la figure 4 représente de façon partielle et schématique, par des vues en coupe (A), (B) et (C), des étapes d'un mode de mise en œuvre d'un procédé de fabrication du circuit de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on prend pour exemple une application aux circuits de protection contre les décharges électrostatiques mais les modes de réalisation décrits de tranchées isolantes s'appliquent plus généralement à tout circuit intégré utilisant des tranchées d'isolation.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les modes de réalisation décrits ci-après s'appliquent aux circuits intégrés, notamment pour les protéger des décharges électrostatiques.

Les décharges électrostatiques (ESD, electrostatic discharge) se produisent entre deux éléments, présentant des potentiels électriques différents. Cela se traduit par le passage d'un courant électrique, entre ces deux éléments, afin d'équilibrer les potentiels. Les décharges électrostatiques, fréquentes entre autres lors de la fabrication des circuits intégrés, peuvent entrainer sur les circuits et/ou les composants un dysfonctionnement partiel ou total de ceux-ci.

Les circuits intégrés actuels intègrent généralement des dispositifs internes de protection contre des décharges électrostatiques. Les dispositifs de protection contre les décharges électrostatiques s'apparentent généralement, dans leur fonctionnement, à des composants tels que des transistors MOS, des thyristors, et plus particulièrement des diodes.

Ces dispositifs évacuent (dérivent) le courant lorsque celui-ci est trop important et dépasse un certain seuil. Cette dérivation permet de protéger le circuit car elle évite aux courants trop élevés de le traverser, et ainsi de le détériorer.

Dans un circuit intégré, les structures ESD peuvent être isolées du reste du circuit par des tranchées d'isolation peu profondes (STI, Shallow Trench Isolation) ou des tranchées d'isolation profondes (DTI, Deep Trench Isolation). De telles tranchées sont, plus généralement, présentes dans un circuit intégré pour séparer (isoler) des composants réalisés dans un substrat.

Les tranchées d'isolation, sont habituellement revêtues d'une couche d'oxyde de silicium procurant l'isolation, puis remplies de silicium polycristallin (poly-Si) .

Selon les modes de réalisation et de mise en œuvre décrits, on prévoit de remplacer le silicium polycristallin par un gaz, de préférence de l'air ou un gaz présent dans l'atmosphère contrôlée de la chambre de traitement du substrat. On tire ainsi profit de la permittivité relative faible (proche de l'unité) des gaz par rapport à celle du silicium polycristallin (de l'ordre de 11-12). Cela permet, à largeur de tranchée égale, de réduire la capacité électrique de la tranchée, ce qui améliore l'efficacité de la protection ESD.

En variante, les tranchées ne sont pas revêtues d'oxyde et sont intégralement constituées de gaz.

On aurait pu craindre que la présence d'air nuise au fonctionnement du circuit. En effet, on cherche habituellement à éviter la présence d'air ou de gaz dans les substrats afin d'éviter de fragiliser les structures. Toutefois, on s'aperçoit qu'en remplissant toute la tranchée d'air sec, cela n'est pas gênant.

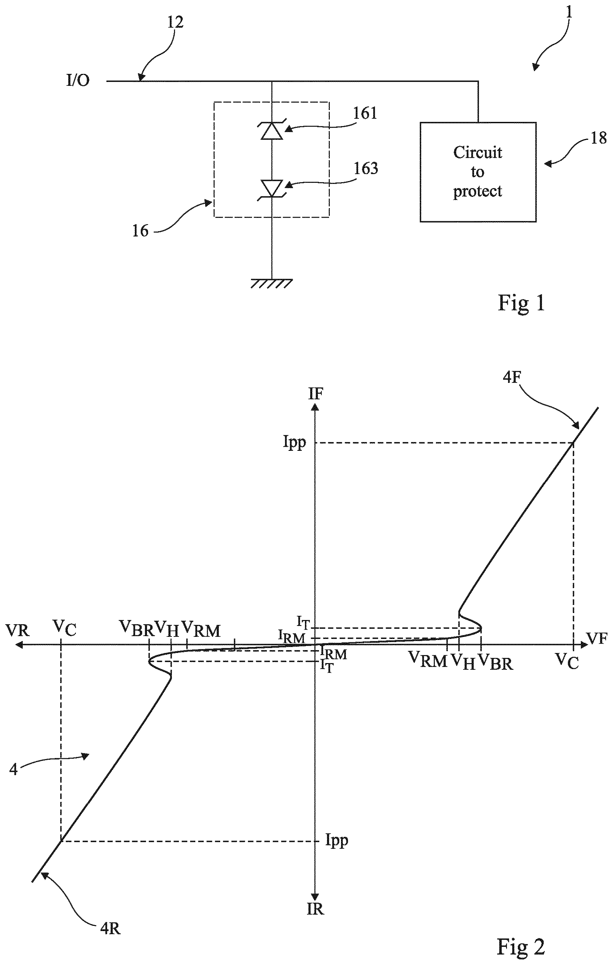

La figure 1 représente, de façon très schématique, un exemple de circuit électronique de protection contre des décharges électrostatiques du type auquel s'appliquent les modes de réalisation décrits.

On considère, dans l'exemple du circuit électronique de la figure 1, un circuit de protection ESD 16 d'un seul plot 12 d'entrée/sortie (I/O) d'un circuit intégré. Toutefois, un circuit intégré possède généralement plusieurs plots 12 d'entrée/sortie. Chaque plot 12 d'entrée/sortie est alors généralement protégé par un circuit de protection ESD 16.

Le dispositif 1 représenté en figure 1 comprend, entre autres, le plot 12 d'entrée/sortie (I/O) du circuit à protéger 18 (Circuit to protect), relié à la masse par le circuit de protection ESD 16. En pratique, un deuxième circuit 16 identique relie le plot 12 à un rail d'alimentation, par exemple positif.

Le circuit ESD 16, ou protection ESD, comprend deux diodes Zener 161 et 163 montées en anti-série entre le plot 12 et, dans l'exemple représenté, la masse. Les deux diodes 161 et 163 sont interconnectées par leurs anodes. La diode 161 est reliée, de préférence connectée, par sa cathode au plot 12 d'entrée/sortie et au circuit à protéger 18. La diode 163 est reliée, de préférence connectée, par sa cathode à la masse.

Le fonctionnement d'un circuit de protection ESD est en lui-même connu. Il sera brièvement rappelé ci-dessous.

La figure 2 représente un exemple de caractéristique courant-tension d'un dispositif de protection contre des décharges électrostatiques.

La caractéristique courant-tension 4 de la figure 2 correspond, par exemple, à celle du circuit équivalent exposé en relation avec la figure 1.

La courbe 4 représente une variation d'intensité du courant électrique direct IF (forward current), ou inverse IR (reverse current), parcourant le circuit ESD 16. Cette intensité est fonction d'une tension de polarisation directe VF (forward voltage) du circuit ESD 16, ou d'une tension de polarisation inverse VR (reverse voltage).

La courbe 4, en figure 2, est divisée en deux portions :
une portion 4R (à gauche, en figure 2) correspondant à des variations du courant inverse IR en fonction de la tension de polarisation inverse VR ; et
une portion 4F (à droite, en figure 2) correspondant à des variations du courant direct IF en fonction de la tension de polarisation directe VF.

Les portions 4R et 4F sont, au signe près, sensiblement identiques. Ainsi, uniquement la portion 4F sera détaillée par la suite.

En fonctionnement normal, la tension de polarisation directe VF du circuit ESD 16 peut prendre des valeurs comprises entre 0 V et une tension limite V_{RM} (Maximum Working Voltage). Cette tension limite V_{RM} correspond à la tension maximale prévue pour une application donnée. La tension limite V_{RM} est, par exemple, de l'ordre de 16 V. Lorsque le circuit 16 est polarisé avec une tension inférieure à cette tension limite V_{RM}, un courant dit de fuite I_{RM}, traverse le circuit 16.

En cas de surtension due, par exemple, à une décharge électrostatique, la tension de polarisation VF excède une tension de déclenchement V_{BR} (Breakdown Voltage). La tension V_{BR} est habituellement définie pour une valeur I_{T} donnée de courant de test. Ce courant de test I_{T} est généralement compris entre 1 mA et 20 mA.

Afin d'éviter un déclenchement intempestif de la protection ESD 16, on choisit la tension de déclenchement V_{BR} pour qu'elle soit supérieure à la tension limite V_{RM}. Par exemple, la tension de déclenchement V_{BR} est supérieure de 10 à 15 % à la tension limite V_{RM}.

Lorsque la tension de déclenchement V_{BR} est dépassée, c'est-à-dire une fois la protection déclenchée, le circuit 16 voit à ses bornes une tension inférieure à la tension de déclenchement V_{BR}. Ce phénomène est appelé retournement. La tension de polarisation peut alors diminuer jusqu'à une valeur de tension minimale ou tension de maintien V_{H} (Holding Voltage).

La limite de protection est définie par une tension dite de blocage V_{C} (Clamping Voltage) qui correspond à un maximum d'intensité Iₚₚ (Peak Pulse Current) acceptable par la protection 16.

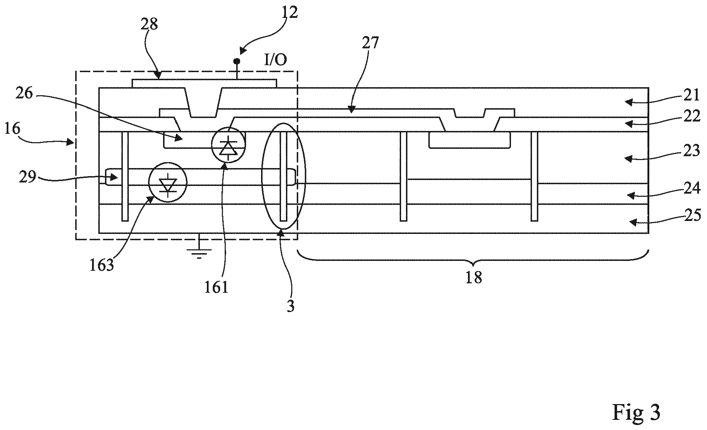

La figure 3 est une vue en coupe, partielle et schématique, d'un circuit de protection contre des décharges électrostatiques réalisé sous forme intégré.

La figure 3 représente un mode de réalisation d'un circuit intégré pourvu d'une fonction de protection ESD. Le dispositif représenté en figure 3 comprend un plot 12 d'entrée/sortie (I/O). Le circuit intégré comprend un circuit de protection ESD 16 (en pointillés en figure 3) et un circuit protégé 18, reliés au plot 12.

Seule la partie du circuit intégré correspondant au circuit de protection ESD 16 sera détaillée ci-après.

Le circuit ESD 16 est réalisé dans un substrat 25 semiconducteur du circuit intégré. Le substrat 25 est constitué d'un matériau d'un premier type de conductivité, par exemple du silicium monocristallin dopé de type n.

Le dispositif 16 est constitué des couches suivantes, en partant du substrat 25 :
une première couche 24 épitaxiée, du premier type de conductivité n ;
une deuxième couche 29 enterrée, d'un deuxième type conductivité p, fortement dopée, qui s'étend sensiblement sur toute la surface du circuit de protection 16 ;
une troisième couche 23, du deuxième type de conductivité p et faiblement dopée ; et
une quatrième couche ou zone 26 formée dans la couche 23, du premier type de conductivité n et fortement dopée.

L'empilement des couches 24, 29, 23 et 26 est isolé électriquement du reste du circuit intégré par des tranchées 3. Les tranchées 3 s'étendent depuis la face avant de la couche 23 (supérieure) jusqu'au substrat 25. La zone 26 constitue une zone de reprise de contact et ne s'étend pas jusqu'aux tranchées 3.

Le substrat 25 est relié, de préférence connecté, à la masse par sa face arrière.

L'ensemble est recouvert par une cinquième couche 22 isolante. Cette couche 22 est ouverte au niveau de la zone 26 de reprise de contact.

Une piste 27 de raccordement, gravée dans un niveau de métallisation, relie la zone 26 et des zones de reprise de contact du circuit 18, destinées à être reliées au plot 12.

Une sixième couche 21 de passivation, recouvre l'ensemble de la structure (la couche isolante 22 et la piste de raccordement 27).

La couche de passivation 21 est ouverte pour permettre une connexion de la piste 27 à un plot conducteur 28 (UBM, Under Bump Metallisation). Le plot 28 est destiné à recevoir une patte de raccordement extérieure ou une bille de connexion.

La deuxième couche 29 et la troisième couche 23 forment respectivement, avec la première couche 24 et la zone 26, des jonctions p-n. Dans cet exemple :
la deuxième couche 29 et la première couche 24 forment la diode 163, dont la deuxième couche 29 définit l'anode et la première couche 24 définit la cathode ; et
la troisième couche 23 et la zone 26 forment la diode 161, dont la zone 26 définit la cathode et la troisième couche 23 définit l'anode.

La diode 161 est reliée au plot 12 par la piste 27. La diode 163 est reliée à la masse, par le substrat 25. Les deux diodes 161 et 163 sont interconnectées, par leurs anodes.

A titre d'exemple particulier de réalisation, la conductivité de la troisième couche 23 est comprise entre 4 et 6 Ω.cm, de préférence environ égale à 5 Ω.cm, cette conductivité étant préférentiellement égale à 5 Ω.cm.

Toujours à titre d'exemple particulier de réalisation, la couche 21 de passivation est du poly(p-phénylène-2,6-benzobisoxazole) (PBO). La couche 21 de passivation a, par exemple, une épaisseur comprise entre 3 et 10 µm, de préférence environ égale à 6 µm, l'épaisseur étant préférentiellement égale à 6 µm.

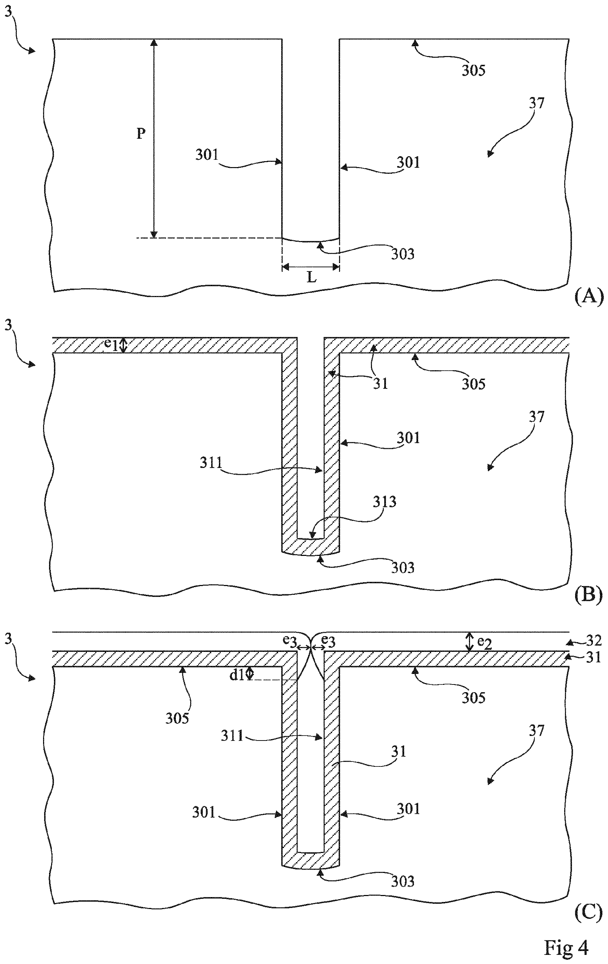

La figure 4 représente de façon partielle et schématique, par des vues en coupe (A), (B) et (C), des étapes d'un mode de mise en œuvre d'un procédé de fabrication du circuit de la figure 3.

Ces vues ne représentent que la formation d'une tranchée 3. En pratique, comme cela est usuel dans la fabrication des circuits intégrés, un grand nombre de tranchées 3 est réalisé en même temps sur la plaquette semiconductrice.

On commence (vue (A)) par graver une tranchée 3 dans un empilement ou substrat semi-conducteur 37.

La tranchée 3 est gravée, par exemple, dans le substrat 37 par une gravure ionique réactive profonde (DRIE, Deep Reactive Ion Etching). Elle s'étend d'une face supérieure ou avant 305 du substrat 37 et comprend deux parois latérales 301 et un fond 303. Les dimensions de la tranchée 3 sont sa profondeur P, et sa largeur L.

La profondeur P correspond à la distance entre la face supérieure 305 et le fond 303 de la tranchée 3. La largeur L correspond à la distance entre les deux parois latérales 301.

La profondeur P est, par exemple, comprise entre 10 et 25 µm, de préférence entre 15 et 20 µm, la profondeur P étant préférentiellement égale à environ 17 µm, de préférence égale à 17 µm.

La largeur L est, par exemple, comprise entre 0,5 et 4 µm, de préférence entre 1 et 2 µm, la largeur L étant préférentiellement égale à environ 1,6 µm, par exemple égale à 1,6 µm.

Optionnellement, (vue (B)), les parois 301 et le fond 303 de la tranchée 3 font l'objet, avec la face supérieure 305 du substrat 37, d'une oxydation thermique, par un oxyde 31 (deuxième oxyde). L'oxyde 31 thermique est, par exemple, du dioxyde de silicium (SiO₂).

L'oxyde 31 forme une couche uniforme, d'épaisseur e₁, sur les parois 301 et 303 et sur la face supérieure 305. On obtient, après oxydation, des parois latérales 311 et un fond 313. L'épaisseur e₁ de la couche d'oxyde 31 est, par exemple, comprise entre 100 et 900 nm, de préférence entre 200 et 250 nm, l'épaisseur e₁ étant préférentiellement égale à environ 215 nm, par exemple égale à 215 nm.

A partir de l'étape (A), ou de l'étape (B) en cas d'oxydation de la tranchée, on dépose une couche 32 au dessus de la tranchée de façon à former un bouchon. L'air ou le gaz ambiant (dans l'enceinte de traitement lors de cette étape) est alors piégé dans la tranchée 3.

Le gaz est un gaz diélectrique et est, par exemple, de l'air sec, du diazote, de l'argon ou un gaz résiduel utilisé pour la fabrication des tranchées 3 (par exemple, du TEOS - l'orthosilicate de tétraéthyle).

Le dépôt de la couche 32 est non-conforme au dessus de la tranchée.

Le dépôt de la couche 32 est réalisé, par exemple, par un dépôt chimique en phase vapeur assisté par plasma (PECVD, Plasma Enhanced Chemical Vapor Deposition).

Ainsi, le matériau 32 est ionisé dans un autre gaz pour former un plasma. L'autre gaz est, par exemple, du TEOS. Les conditions de manipulation (température du substrat et pression) sont fixées afin d'avoir un coefficient de collage (du matériau 32 présent dans le plasma) élevé. A titre d'exemple particulier, les conditions sont fixées pour que le collage d'une particule du matériau 32, présent dans le plasma, survienne après seulement une ou deux collisions. La couche 32 forme ainsi un bouchon en surface de la tranchée 3.

La couche 32 s'introduit dans la tranchée 3 sur une profondeur ou distance d1 (à partir de la face 305), le long des parois 311. La profondeur d1 est, par exemple, comprise entre 100 nm et 17 µm, de préférence entre 1 µm et 17 µm, l'épaisseur étant préférentiellement égale à environ 4 µm, par exemple égale à 4 µm.

La couche 32 s'introduit dans la tranchée 3 et son épaisseur dans la tranchée suit un gradient. Au sommet de la tranchée (au niveau de la face supérieure de la couche 31 ou de l'empilement 37 en l'absence de la couche 31), la couche 32 a une épaisseur horizontale ou largeur e₃. L'épaisseur e₃ de la couche 32 est, par exemple comprise entre 100 nm et 10 µm, de préférence entre 100 nm et 3 µm, l'épaisseur e₃ étant préférentiellement égale à environ 0,8 µm, par exemple égale à 0,8 µm.

De part et d'autre de la tranchée 3, la couche 32 a une épaisseur e₂.

Le rapport des épaisseurs e₃ et e₂ est, par exemple, environ égal à 0,8. En d'autres termes, l'épaisseur e₃ est, par exemple, égale à environ 80 % de l'épaisseur e₂. L'épaisseur e₂ est, par exemple comprise entre 100 nm et 10 µm, de préférence entre 100 nm et 3 µm, l'épaisseur e₂ étant préférentiellement égale à environ 1 µm, par exemple égale à 1 µm.

Le matériau de la couche 32 est, par exemple, un oxyde (premier oxyde), de préférence du dioxyde de silicium (SiO₂).

Dans un autre mode de réalisation, le dépôt de la couche 32 peut être réalisé par dépôt physique en phase vapeur (PVD, physical vapor deposition)

L'introduction de gaz dans une tranchée permet de diminuer la permittivité relative (εᵣ) de la tranchée. Afin de diminuer la capacité de la tranchée 3, la largeur peut être augmentée. Toutefois, structurellement, il est important que la tranchée soit suffisamment étroite pour que le bouchon se forme. La largeur L, qui permet de concilier ces deux exigences est dite largeur critique. La largeur critique est environ égale à 1,6 µm, de préférence, égale à 1,6 µm pour une profondeur P de la tranchée 3 environ égale à 17 µm.

Un avantage des modes de réalisation et de mise en œuvre décrits est la diminution de la capacité de la tranchée 3 afin de diminuer les contributions négatives, des effets parasites, sur les performances du circuit. En effet, pour une tension de blocage (V_{C}) de 30 V à 16 A, la capacité de la tranchée est environ égale à 130 fF.

Un autre avantage des modes de réalisation et de mise en œuvre décrits est l'augmentation de la rigidité diélectrique de la tranchée, par rapport à une tranchée remplie de silicium polycristallin.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art.

Enfin, la mise en œuvre pratique des modes de réalisation et variantes décrits est à la portée de l'homme du métier à partir des indications fonctionnelles données ci-dessus.

## Revendications

1. Dispositif de protection contre des décharges électrostatiques comprenant au moins une tranchée isolante (3) dans un substrat semi-conducteur, la tranchée (3) comportant un espace clos qui contient un gaz.

2. Dispositif selon la revendication 1, dans lequel le volume de l'espace clos comprenant le gaz correspond à environ 60 pourcents du volume de la tranchée.

3. Procédé de fabrication d'un dispositif selon la revendication 1 ou 2, comportant une tranchée isolante (3) dans un substrat (37) semi-conducteur, comprenant une étape d'enfermement d'un gaz dans un espace clos.

4. Procédé selon la revendication 3, comprenant une étape d'ouverture du substrat (37) par gravure ionique réactive profonde pour former la tranchée (3).

5. Procédé selon la revendication 4, dans lequel la tranchée (3) est fermée par un dépôt, non-conforme, d'un premier oxyde (32) à la surface de celle-ci.

6. Procédé selon la revendication 5, dans lequel le premier oxyde (32) est du dioxyde de silicium.

7. Procédé selon la revendication 5 ou 6, dans lequel le dépôt non-conforme est effectué par dépôt chimique en phase vapeur assisté par plasma.

8. Procédé selon la revendication 5 ou 6, dans lequel le dépôt non-conforme est effectué par dépôt physique en phase vapeur.

9. Procédé selon l'une quelconque des revendications 5 à 8, dans lequel le premier oxyde (32) a une épaisseur comprise entre 0,1 et 3 µm, de préférence entre 0,5 et 1,5 µm, l'épaisseur étant préférentiellement égale à environ 1 µm, par exemple égale à 1 µm.

10. Procédé selon l'une quelconque des revendications 5 à 9, dans lequel les parois (301, 303, 311, 313) de la tranchée (3) sont oxydées thermiquement par un deuxième oxyde (31).

11. Procédé selon la revendication 10, dans lequel le deuxième oxyde (31) est du dioxyde de silicium.

12. Procédé selon la revendication 10 ou 11, dans lequel le deuxième oxyde (31) a une épaisseur comprise entre 100 et 900 nm, de préférence entre 200 et 250 nm, l'épaisseur étant préférentiellement égale à environ 215 nm, par exemple égale à 215 nm.

13. Procédé selon l'une quelconque des revendications 5 à 12, dans lequel la tranchée (3), avant oxydation, a une largeur (L) comprise entre 0,5 et 4 µm, de préférence entre 1 et 2 µm, la largeur étant préférentiellement égale à environ 1,6 µm, par exemple égale à 1,6 µm.

14. Procédé selon l'une quelconque des revendications 5 à 13, dans lequel la tranchée (3), avant oxydation, a une profondeur (P) comprise entre 10 et 25 µm, de préférence entre 15 et 20 µm, la profondeur étant préférentiellement égale à environ 17 µm, de préférence égale à 17 µm.

15. Procédé selon l'une quelconque des revendications 3 à 14, dans lequel le gaz est choisi parmi de l'air sec, du diazote, de l'argon ou un gaz utilisé pour la fabrication de la tranchée (3), par exemple de l'orthosilicate de tétraéthyle.

16. Dispositif selon la revendication 1 ou 2, possédant une tension de blocage (V_{C}) inférieure ou égale à 30 V.
